# EUROPEAN PATENT APPLICATION

(11) **EP 4 012 791 A1**
(43) Date of publication of application: **15.06.2022**
(21) Application number: 20849420.3
(22) Date of filing: 29.07.2020
(51) Int. Cl.: H01L 43/08, H01L 43/10, G01R 33/09

(54) **MAGNETORESISTIVE ELEMENT AND MAGNETORESISTIVE DEVICE**

(30) Priority: 06.08.2019 JP 2019144574
(71) Applicant: Hitachi High-Tech Corporation, Minato-ku Tokyo 105-6409 (JP)
(72) Inventor: FUKATANI, Naoto, Tokyo 100-8280 (JP); HAYAKAWA, Jun, Tokyo 100-8280 (JP)
(74) Representative: Strehl Schübel-Hopf & Partner
(86) International application number: PCT/JP2020/028962
(87) International publication number: WO 2021/024870

(57) **Abstract**

Provided is a magneto-resistance effect element formed by sequentially laminating a ferromagnetic fixing layer, a ferromagnetic free layer, and a protective layer, which is capable of efficiently detecting the magnetic field above the magneto-resistance effect element without deteriorating the function as the magnetic sensor. The GMR laminated film for the magneto-resistance effect element includes the ferromagnetic free layer, and the protective layer formed on the ferromagnetic free layer to be protected from oxidation. The protective layer is formed as an oxide antiferromagnetic substance, and has its film thickness of 10 nm or smaller.

## Description

### Technical Field

The present invention relates to a magneto-resistance effect element and a magneto-resistance effect device. Specifically, the present invention is applicable to the magneto-resistance effect element and the magneto-resistance effect device, which cause giant magneto-resistance change in the low magnetic field area.

### Background Art

The recent magnetic sensor that employs the magneto-resistance effect element is capable of detecting a minute magnetic field change. The sensor has been used for various applications such as the reading head of the hard disk drive. The generally employed giant magneto-resistance effect element has a basic structure formed as a GMR (Giant Magneto Resistance) laminated layer derived from sequentially laminating the ferromagnetic fixing layer, the non-magnetic intermediate layer, and the ferromagnetic free layer from the lower side. The free layer has the magnetizing direction sensitively changeable to variation in the external magnetic field. Meanwhile, the fixing layer is designed to have its composing material or base laminated structure not to change the magnetizing direction depending on the external magnetic field. In the basic structure, the relative angle in the magnetizing direction between the free layer and the fixing layer changes depending on the external magnetic field, resulting in substantial change in electric resistance. Such phenomenon is called a giant magneto-resistance effect (GMR effect).

The spin valve GMR laminated film of bottom fixing type including the fixing layer at the lower side and the free layer formed thereon is used for detecting the magnetic field that enters the GMR laminated film from the upper side. The protective layer as the surface layer is formed on the free layer to prevent the GMR laminated film from being deteriorated by the external environment (chemical reaction such as oxidation). The protective layer is required to exhibit the characteristic of excellent permeability of the magnetic field.

Patent Literature 1 (Japanese Unexamined Patent Application Publication No. 2000-276710) discloses the use of the non-magnetic high-resistance layer for the protective layer to minimize the shunt current to the protective layer so that the electric current can be efficiently applied to the ferromagnetic fixing layer, the non-magnetic intermediate layer, and the ferromagnetic free layer, which exhibit the GMR effect. The literature also discloses the protective layer functioning as a specular reflection layer that reflects electrons without changing an electron spin direction of the conduction electron so that the GMR effect is further facilitated. Patent Literature 2 (United States Patent Application Publication No. 2002/0012207) discloses that the spin valve type GMR element is provided with the specular reflection layer formed on the uppermost layer in contact with the free layer so that the resultant specular reflection effect facilitates the GMR effect.

### Citation List

### Patent Literature

Patent Literature 1: Japanese Unexamined Patent Application Publication No. 2000-276710
Patent Literature 2: United States Patent Application Publication No. 2002/0012207

### Summary of Invention

### Technical Problem

Patent Literature 1 discloses that the upper layer in contact with the upper surface of the free layer is formed of the non-magnetic high-resistance layer. The upper layer as the non-magnetic substance cannot exhibit sufficient permeability of the magnetic field. Patent Literature 2 discloses that the antiferromagnetic substance is available as the material for the specular reflection layer that forms the upper layer in contact with the upper surface of the free layer as well as the non-magnetic substance. Generally, the antiferromagnetic substance is magnetically coupled with the free layer to fix its magnetizing direction, and prevents the free layer from executing its intrinsic function.

It is required to provide the GMR element having the protective layer that exhibits sufficient permeability of the magnetic field while maintaining the free layer function.

Other tasks and new characteristics will be clarified referring to the description and drawings of the specification hereinafter. Solution to Problem

The representative embodiment among those disclosed herein will be briefly described.

The semiconductor device according to the representative embodiment is configured as the magneto-resistance effect element formed by laminating an antiferromagnetic layer, a ferromagnetic fixing layer, a non-magnetic layer, a ferromagnetic free layer, and a protective layer. The protective layer formed as an oxide antiferromagnetic substance layer has a film thickness of 10 nm or smaller.

### Advantageous Effects of Invention

The representative embodiment allows improvement in the performance of the magneto-resistance effect element. Especially, the magnetic field above the magneto-resistance effect element can be efficiently detected.

### Brief Description of Drawings

Fig. 1 is a sectional view of a magneto-resistance effect laminated film which constitutes a magneto-resistance effect element according to a first embodiment of the present invention.
Fig. 2 is a sectional view of a magneto-resistance effect laminated film which constitutes a magneto-resistance effect element according to a second embodiment of the present invention.
Fig. 3 is a graph representing the relation between a film thickness of the protective layer and an exchange coupling field.
Fig. 4 is a plan view of a magneto-resistance effect device provided with the magneto-resistance effect element according to the second embodiment of the present invention.
Fig. 5 is a table that represents respective values of MR ratio and coercive force of an experiment example 2 and a comparative example.

### Description of Embodiments

Embodiments of the present invention will be described referring to the drawings. In all the drawings, the members each having the same function will be designated with the same code to omit the repetitive explanation. In the embodiment, explanations of the same or similar parts will be omitted unless otherwise required.

### First Embodiment

An explanation will be made with respect to improvement in the performance of the magneto-resistance effect element provided with the GMR (Giant Magneto Resistance) laminated film including the base layer, the antiferromagnetic layer, the ferromagnetic fixing layer, the non-magnetic intermediate layer, the ferromagnetic free layer, and the protective layer, which are sequentially laminated on the substrate. Specifically, the explanation will be made with respect to further efficient detection of the magnetic field penetrating from above the protective layer. The present embodiments are characterized mainly by the material for forming the protective layer and the film thickness thereof.

### <Structure of magneto-resistance effect element>

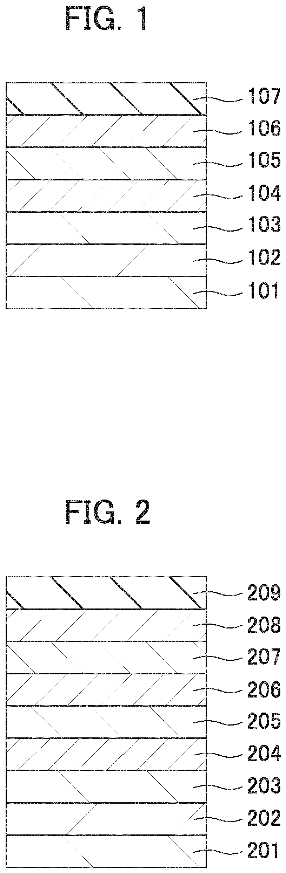

Fig. 1 illustrates a structure of the GMR laminated film according to the embodiment. The GMR laminated film of the embodiment includes a substrate 101, and a base layer 102 formed on the substrate 101. The base layer 102 executes functions of flattening the GMR laminated film, and crystallizing films that constitute the GMR laminated film formed on the base layer 102. The base layer 102 is made of the metal that contains Ta (tantalum), Ti (titanium), Ni (nickel), Cr (chromium), or Fe (iron). Specifically, the base layer 102 may be made of one or more kinds of materials in the form of the laminated film including two layers, for example, a Ta layer and a NiCr (nickel chrome) layer. The base layer 102 with small film thickness cannot execute its intrinsic function. Accordingly, it is preferable for the base layer 102 to have its film thickness of 1 nm or larger.

An antiferromagnetic layer 103 is formed on the base layer 102. The antiferromagnetic layer 103 is required to be kept magnetized at a room temperature or higher in which the GMR laminated film is operable. Preferably, the antiferromagnetic layer 103 is made of an oxide that contains one or more elements of Ni, Cr, Fe, Co (cobalt), and Mn (manganese). Alternatively, the antiferromagnetic layer 103 is made of a metal that contains one or more elements of Fe, Mn, Pt (platinum), and Ir (iridium). The antiferromagnetic layer 103 is made of the material with no magnetic moment as a whole. In a micro-viewpoint, the antiferromagnetic layer 103 contains magnetic atoms having the respective directions of magnetic moments arranged alternately reversed from each other with regularity. The antiferromagnetic layer 103 of the embodiment includes only two kinds of magnetic moments directed opposite to each other along the upper surface of the substrate 101, for example. As a result, each spontaneous magnetization is cancelled to make the entire spontaneous magnetization of the antiferromagnetic layer 103 zero.

A ferromagnetic fixing layer 104 is formed on the antiferromagnetic layer 103. In the case of the single ferromagnetic fixing layer 104, the magnetizing direction becomes unfixable. As the antiferromagnetic layer 103 and the ferromagnetic fixing layer 104 are magnetically coupled via the respective interfaces, the magnetizing direction of the ferromagnetic fixing layer 104 is fixed. The ferromagnetic fixing layer 104 is required to prevent its magnetizing direction from being easily changed even in the large external magnetic field. Preferably, the ferromagnetic fixing layer 104 is made of the material that contains at least one of Fe, Ni, Co, and alloys thereof.

A non-magnetic intermediate layer (non-magnetic layer) 105 is formed on the ferromagnetic fixing layer 104. A ferromagnetic free layer 106 is formed on the non-magnetic intermediate layer 105. The non-magnetic intermediate layer 105 is required to have a sufficient film thickness to dissipate the magnetic coupling between the ferromagnetic free layer 106 formed on the non-magnetic intermediate layer 105, and the ferromagnetic fixing layer 104 formed beneath the non-magnetic intermediate layer 105. Preferably, the film thickness of the non-magnetic intermediate layer 105 is 1 nm or larger, for example. The GMR effect is derived from the area including the ferromagnetic fixing layer 104, the non-magnetic intermediate layer 105, and the ferromagnetic free layer 106. Preferably, the non-magnetic intermediate layer 105 is made of the highly conductive material for the purpose of efficient electric current application to such area. It is preferable to use such material as Cu for forming the non-magnetic intermediate layer 105.

In the case of the single ferromagnetic free layer 106 formed on the non-magnetic intermediate layer 105, it becomes the ferromagnetic layer having its magnetizing direction unfixable. The ferromagnetic free layer 106 serves as a sensing position where the magnetizing direction changes upon detection of the weak magnetic field generated from an inspection target above the magneto-resistance effect element. Accordingly, the ferromagnetic free layer 106 is required to be made of the material having the magnetizing direction easily changeable by variation of the external magnetic field. That is, the ferromagnetic free layer 106 has to exhibit good soft magnetic characteristics. Preferably, the material for forming the ferromagnetic free layer 106 contains at least one of Fe, Ni, Co, and alloys thereof. It is especially preferable to set the content ratio of Ni to 50% or higher.

A protective layer 107 is formed on the ferromagnetic free layer 106. The GMR laminated film includes the substrate 101, and the layers sequentially laminated on the substrate 101, including the base layer 102, the antiferromagnetic layer 103, the ferromagnetic fixing layer 104, the non-magnetic intermediate layer 105, the ferromagnetic free layer 106, and the protective layer 107. The protective layer 107 entirely covers the upper surface of the ferromagnetic free layer 106 while being in contact therewith.

The protective layer 107 serves to prevent the ferromagnetic free layer 106 from being degraded by the external environment of the GMR laminated film. That is, the protective layer 107 serves to prevent the ferromagnetic free layer 106 from being deteriorated by the chemical reaction such as oxidation to avoid impairment of reliability of the magneto-resistance effect element. The protective layer 107 has its thickness ranging from 0.5 to 10 nm. The protective layer 107 has its thickness of at least 0.5 nm to satisfy the need of maintaining the crystallinity. One of main characteristics of the embodiment lies in the thickness of the protective layer 107, which is set to 10 nm.

Another main characteristic of the embodiment lies in the protective layer 107 as an oxide antiferromagnetic substance. Specifically, the protective layer 107 is made of the oxide that contains one or more elements of Ni, Cr, Fe, Co, and Mn. Each of the antiferromagnetic layer 103 and the protective layer 107 is made of the antiferromagnetic substance, and may be formed of the same material. That is, it is possible to use the oxide of the same element (Ni, Cr, Fe, Co, or Mn) for forming the antiferromagnetic layer 103 and the protective layer 107.

In the embodiment, the surface of the protective film 107 is molecularly modified to allow coupling of molecules that contain the detection target. The substance that causes a leakage magnetic field is further specifically coupled to allow the protective film to serve as a biosensor. The surface of the protective film 107 is subjected to an oxygen plasma treatment for converting oxygen into a hydroxyl group, and further to silane coupling reaction with the amino group to allow molecular modification of the surface of the protective film 107 with 3-aminopropyl triethoxysilane (APTES). It is preferable to use NiO, α-Fe₂O₃, CoO, α-Cr₂O₃, or MnO as the material for forming the protective film 107. It is more preferable to use α-Fe₂O₃ or α-Cr₂O₃ each with higher surface density of oxygen atom.

The structure of the GMR laminated film can be easily confirmed through X-ray diffraction (XRD). The structure of the GMR laminated film can be confirmed by observing the lattice image using an electron microscope such as TEM (Transmission Electron Microscope). The crystal structure and lamination structure of a single crystal or polycrystal of the GMR laminated film can be confirmed by observing a spot pattern or a ring pattern of the electron beam diffraction image. The composition distribution of each layer of the GMR laminated film can be confirmed using EPMA (Electron Probe Micro Analyzer) such as EDX (Energy dispersive X-ray spectrometry). The composition distribution can be confirmed by executing SIMS (Secondary Ion Mass Spectrometry), X-ray photoelectron spectroscopy, or ICP (Inductively Coupled Plasma) emission spectrophotometric analysis process.

### <Operation of magneto-resistance effect element>

The magneto-resistance effect element of the embodiment is used for detecting the leakage magnetic field generated from the detection target (for example, magnetic particle) positioned above the protective layer 107 in the laminating direction of the GMR laminated film as illustrated in Fig. 1 (height direction, longitudinal direction, vertical direction). As the detection target approaches the GMR laminated film, the magnetizing direction of the ferromagnetic free layer 106 is changed by 180° owing to the leakage magnetic field. In this instance, the magnetizing direction of the ferromagnetic fixing layer 104 is fixed to be kept unchanged. If magnetizing directions of the ferromagnetic free layer 106 and the ferromagnetic fixing layer 104 become relatively opposite to each other, that is, antiparallel with each other, the resistance value of the GMR laminated film is increased. If the GMR laminated film and the detection target move apart from each other, the ferromagnetic free layer 106 is not influenced by the leakage magnetic field. The magnetizing directions of the ferromagnetic free layer 106 and the ferromagnetic fixing layer 104 then become the same. This may lower the resistance value of the GMR laminated film.

Observation of change in the electric resistance value of the GMR laminated film allows detection of a magnetic state of the detection target.

### <Method of producing GMR laminated film>

The method of producing the GMR laminated film will be described. Each layer of the GMR laminated film can be produced through the sputtering process in ultra-high vacuum at the ultimate vacuum of 1.0 × 10⁻⁵ Pa or lower. Each material for forming the respective layers can be prepared using a sputtering target with the same composition as that of each layer to be prepared. Preferably, Ar (argon) pressure in formation of the film is 10 mTorr or lower for the purpose of obtaining the flat layer with excellent crystallinity and orientation. After formation of the film, the annealing process is executed in the magnetic field in ultra-high vacuum of 1.0 × 10⁻⁵ Pa or lower. Preferably, the annealing temperature is in the range from 200°C to 400°C inclusive so that the flat layer with excellent crystallinity and orientation is obtained. More preferably, the annealing temperature is in the range from 240°C to 300°C inclusive so that the flat layer with further excellent crystallinity and orientation is obtained. Preferably, the magnitude of the magnetic field during annealing is 5 kOe or larger so that fixation of the magnetizing direction of the ferromagnetic fixing layer is facilitated.

### <Effect of magneto-resistance effect element>

The protective layer is required to be formed on the ferromagnetic free layer so that the ferromagnetic free layer as the sensing position of the GMR laminated film is protected. When detecting the magnetic field penetrating from above the GMR laminated film, it is necessary to detect the magnetic field entering the ferromagnetic free layer as the sensing position through the protective layer. Accordingly, it is essential to use the material with sufficient permeability of the magnetic field for forming the protective layer.

The non-magnetic substance may be used for forming the protective layer as described above. However, the protective layer made of the non-magnetic substance hardly exhibits permeability of the magnetic field to cause attenuation of the magnetic field generated above the GMR laminated film (above the protective layer) in the protective layer. This may cause the risk of difficulty in detection of the magnetic field in the ferromagnetic free layer beneath the protective layer.

In the embodiment, the oxide antiferromagnetic substance is used for forming the protective layer 107 as illustrated in Fig. 1. The oxide antiferromagnetic substance as the oxide allows no permeation of oxygen so that deterioration in the ferromagnetic free layer 106 owing to the external environment can be prevented. The protective layer 107 as the antiferromagnetic substance has smaller magnetic susceptibility compared with the non-magnetic substance. That is, the protective layer 107 as the antiferromagnetic substance is more likely to exhibit permeability of the magnetic field compared with the protective layer as the non-magnetic substance.

In the case where the layer as the antiferromagnetic substance with sufficient film thickness and the layer as the ferromagnetic substance are laminated in contact with each other, the magnetic coupling occurs between those layers to fix the magnetizing direction of the ferromagnetic substance layer. If the magnetizing direction of the ferromagnetic free layer beneath the protective layer is fixed, the ferromagnetic free layer no longer serves as the free layer. The magneto-resistance effect element cannot perform the intrinsic function of its own. Meanwhile, in the embodiment, the film thickness of the protective layer 107 is controlled to be in the range that prevents magnetic coupling between the protective layer 107 and the ferromagnetic free layer 106. Specifically, the film thickness of the protective layer 107 is 10 nm or smaller. This prevents the magnetic coupling between the protective layer 107 and the ferromagnetic free layer 106. Accordingly, the magnetizing direction of the ferromagnetic free layer 106 is not fixed. This makes it possible to improve the magnetic field permeability of the protective layer 107, and to secure normal operation of the magneto-resistance effect element having the ferromagnetic free layer 106 as the sensing position.

The protective layer can be made of the material that exhibits sufficient permeability of the magnetic field compared with the non-magnetic substance without interfering the function of the magneto-resistance effect element as the magnetic sensor. It is possible to efficiently detect the magnetic field above the magneto-resistance effect element. In other words, it is possible to improve detection accuracy, that is, performance of the magneto-resistance effect element.

The grounds for setting the film thickness of the protective layer to 10 nm or smaller in the embodiment will be described in a second embodiment hereinafter.

### Second Embodiment

The GMR laminated film that constitutes the magneto-resistance effect element may have a laminated structure as illustrated in Fig. 2. The GMR laminated film according to the embodiment includes a base layer 202, an antiferromagnetic layer 203, a first ferromagnetic fixing layer 204, a non-magnetic coupling layer 205, a second ferromagnetic fixing layer 206, a non-magnetic intermediate layer 207, a ferromagnetic free layer 208, and a protective layer 209, which are sequentially formed on a substrate 201. The GMR laminated film of the embodiment is capable of detecting the magnetic field penetrating from above the protective layer 209 in the similar manner to the first embodiment.

Unlike the structure as illustrated in Fig. 1, the film includes the first ferromagnetic fixing layer 204 and the second ferromagnetic fixing layer 206, having the non-magnetic coupling layer (non-magnetic layer) 205 intervening therebetween. The magnetizing direction of the first ferromagnetic fixing layer 204 is fixed by the antiferromagnetic layer 203. The magnetizing direction of the second ferromagnetic fixing layer 206 formed above the first ferromagnetic fixing layer 204 via the non-magnetic coupling layer 205 is fixed in the direction opposite to that of the first ferromagnetic fixing layer 204. The magnetizing direction of the second ferromagnetic fixing layer 206 is determined by the film thickness of the non-magnetic coupling layer 205, that is, the distance between the first ferromagnetic fixing layer 204 and the second ferromagnetic fixing layer 206.

The respective magnetizing directions of the first ferromagnetic fixing layer 204 and the second ferromagnetic fixing layer 206 are opposite to each other. In other words, the magnetizing directions of the first ferromagnetic fixing layer 204 and the second ferromagnetic fixing layer 206 are antiparallel with each other. The respective magnetic fields generated from the first ferromagnetic fixing layer 204 and the second ferromagnetic fixing layer 206 loop therebetween. That is, most of the leakage magnetic field from the first ferromagnetic fixing layer 204 passes through the second ferromagnetic fixing layer 206, and most of the leakage magnetic field from the second ferromagnetic fixing layer 206 passes through the first ferromagnetic fixing layer 204. Accordingly, the respective magnetic fields from the first ferromagnetic fixing layer 204 and the second ferromagnetic fixing layer 206 do not affect the external environment.

The foregoing structure is called a laminated antiferromagnetic structure. The laminated antiferromagnetic structure reduces the magnetic field generated from the GMR laminated film. Such structure allows detection of the very weak magnetic field of the magnetic substance as the detection target without changing its magnetic state before and after the detection. This makes it possible to detect the magnetic state accurately. Preferably, at least one of the first ferromagnetic fixing layer 204 and the second ferromagnetic fixing layer 206 contains any one of Co and Co-Fe alloy, and the non-magnetic coupling layer 205 contains at least one of Ru (ruthenium) and Ir.

The laminated film including the first ferromagnetic fixing layer 204, the non-magnetic coupling layer 205 and the second ferromagnetic fixing layer 206 may be regarded as the single ferromagnetic fixing layer. That is, it can be considered that the magneto-resistance effect element of the embodiment has the laminated film corresponding to the ferromagnetic fixing layer 104 of the first embodiment, which includes the first ferromagnetic fixing layer 204, the non-magnetic coupling layer 205, and the second ferromagnetic fixing layer 206.

Examples (experiment examples 1, 2) for preparing a sample with the above-described structure will be described.

### <Experiment example 1>

The inventors prepared a sample for examining a film thickness of the oxide antiferromagnetic substance without being magnetically coupled with the ferromagnetic substance. The prepared GMR laminated film has the same structure as the one illustrated in Fig. 2. The protective layer 209 is made of NiO (nickel oxide) as the oxide antiferromagnetic substance.

In the experiment, the base layer 202 as the laminated film including the Ta film with thickness of 5 nm and the NiFe film with thickness of 5 nm is formed on the Si substrate having its surface coated with a thermal oxide film. The antiferromagnetic layer 203 is made of Ir₂₀Mn₈₀ with its thickness of 6 nm. The first ferromagnetic fixing layer 204 is made of C0₉₀Fe₁₀ with its thickness of 1.6 nm. The non-magnetic coupling layer 205 is made of Ru with its thickness of 0.85 nm. The second ferromagnetic fixing layer 206 is made of Co₉₀Fe₁₀ with its thickness of 1.6 nm. The non-magnetic intermediate layer 207 is made of Cu with its thickness of 2.5 nm. The ferromagnetic free layer 208 includes the film made of Co₉₀Fe₁₀ with its thickness of 1.0 nm, and the film made of Ni₈₁Fe₁₉ with its thickness of 3.5 nm. The protective layer 209 as the oxide antiferromagnetic substance is made of NiO or α-Fe₂O₃.

In this experiment example, a plurality of protective layers 209 each having different film thickness in the range from 2 to 50 nm are prepared for the purpose of measuring an exchange coupling field that varies with the film thickness of the protective layer 209. That is, multiple types of GMR laminated films each including the protective layer 209 having the different film thickness are prepared. Each of the exchange coupling fields (unit: Oe) of the multiple GMR laminated films is measured. The multiple GMR laminated films are annealed for an hour at 240°C under the applied magnetic field of 6 kOe, and then cooled in the furnace.

In the case where the protective layer 209 as the layer (antiferromagnetic oxide layer) made of the oxide antiferromagnetic substance is magnetically coupled with the ferromagnetic free layer 208, a phenomenon is observed that the magnetization curve shifts in accordance with the magnetic coupling force in the interface between those layers. The degree of the magnetization curve shifting is called the exchange coupling field. Meanwhile, in the case where the protective layer 209 as the antiferromagnetic oxide layer is not magnetically coupled with the ferromagnetic free layer 208, the magnetization curve shifting is not observed. The exchange coupling field measures the value around zero.

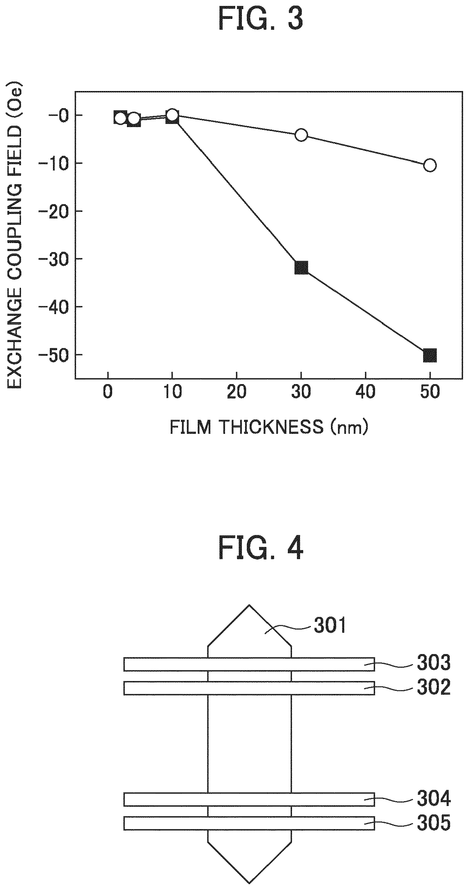

Fig. 3 is a graph that represents results derived from the experiment example, indicating dependence of the exchange coupling field on the film thickness of the protective layer. The x-axis of the graph represents the film thickness of the protective layer 209, and y-axis represents the exchange coupling field. Referring to Fig. 3, each plot point expressed as a white circle represents the case of the protective layer 209 made of NiO, and each plot point expressed as a black square represents the case of the protective layer 209 made of α-Fe₂O₃.

Referring to Fig. 3, in the case where the protective layer 209 is made of either NiO or α-Fe₂O₃, when the film thickness of the protective layer 209 is 50 nm, the magnetic coupling occurs in the interface between the protective layer 209 and the ferromagnetic free layer 208 to generate the exchange coupling field. In the generated exchange coupling field, the MR ratio is increased to make the threshold value of the sensing magnetic field large, which indicates that the weak magnetic field cannot be detected. In the case where the protective layer 209 is made of either NiO or α-Fe₂O₃, when the film thickness of the protective layer 209 is 10 nm or smaller, the exchange coupling field measures zero.

It is found out that no magnetic coupling occurs between the ferromagnetic free layer and the protective layer so long as the thickness of the protective layer is 10 nm or smaller even in the case where the protective layer as the oxide antiferromagnetic substance is formed on the adjacent ferromagnetic free layer. That is, setting the protective layer thickness to 10 nm or smaller allows normal operation of the magneto-resistance effect element without fixing the magnetizing direction of the ferromagnetic free layer. This applies to the case of the magneto-resistance effect element with no laminated antiferromagnetic structure according to the first embodiment.

### <Second experiment example>

A sample of the magneto-resistance effect device having the protective layer made of NiO will be described. The structure of the magneto-resistance effect device will be described later referring to Fig. 4. The magneto-resistance effect device includes the magneto-resistance effect element. The GMR laminated film that constitutes the magneto-resistance effect device used in the example has the same structure as the one illustrated in Fig. 2.

The respective material compositions and film thicknesses of the sequentially laminated layers from the lower side, including the substrate 201, the base layer 202, the antiferromagnetic layer 203, the first ferromagnetic fixing layer 204, the non-magnetic coupling layer 205, the second ferromagnetic fixing layer 206, the non-magnetic intermediate layer 207, and the ferromagnetic free layer 208 are the same as those used in the experiment example 1. The protective layer 209 is made of NiO, and has its thickness of 2.0 nm. In the following description, the GMR laminated film having the protective layer 209 made of NiO will be called the GMR laminated film of the experiment example 2.

A GMR laminated film having the protective layer 209 produced by sequentially laminating the Ru film, Ta film, and Ru film each as the non-magnetic metal is prepared as a comparative example. That is, the laminated film includes the Ru film with thickness of 0.5 nm, the Ta film with thickness of 1.0 nm, and the Ru film with thickness of 0.5 nm. The experiment example 2 and the comparative example are different only in the structure of the protective layer 209. In the following description, the GMR laminated film including the protective layer 209 made of the non-magnetic metal laminated film will be called the GMR laminated film of the comparative example. Both the GMR laminated films of the experiment example 2 and the comparative example are annealed for an hour at 240°C under the applied magnetic field of 6 kOe, and then cooled in the furnace.

The device producing process will be described. The magneto-resistance effect element (GMR laminated film) is applied to the device by implementing the photolithography technique. A photoresist film having a shape of a GMR laminated film pattern 301 as illustrated in the plan view of Fig. 4 is produced on the GMR laminated film through the photolithography technique. Then the photoresist film is used as an etching stop mask for etching through the argon ion milling process to execute the over etching up to the substrate. Thereafter, the photoresist film is removed to obtain the GMR laminated film pattern having a longitudinal length of 80 µm and a lateral length of 300 µm in the planar view.

Then electrodes are formed on the patterned GMR laminated film as described above. The photoresist film is formed on the area other than the one where the electrodes are produced through the photolithography technique. The Ti film with thickness of 15 nm and the Au (gold) film with thickness of 70 nm are sequentially formed through sputtering. The photoresist film is then removed. The electrodes 302 to 305 each formed of the laminated film including the Ti film and the Au film are produced through the lift-off process. Production of the magneto-resistance effect device including the GMR laminated film pattern 301 and the electrodes 302 to 305 as illustrated in Fig. 4 is then substantially completed. The protective layer 209 (see Fig. 2) in the area where the electrodes 302 to 305 are produced is removed using the photolithography technique and the etching process before producing the electrodes 302 to 305 so that the contact resistance between the electrodes 302 to 305 and the GMR laminated film can be reduced. Each of the electrodes 302 to 305 is in contact with the upper surface of the protective layer 209 or the upper surface of the ferromagnetic free layer 208 as illustrated in Fig. 2. Even if the electrodes 302 to 305 are in contact with the upper surface of the protective layer 209 made of the oxide, the thickness of the protective layer 209 is small sufficient to allow electrical coupling between the electrodes 302 to 305 and the entire GMR laminated film pattern 301.

In the planar view, each shorter-side width of the electrodes 302 to 305 is 50 µm, and each longer-side length is 800 µm. The electrodes 302 to 305 extend in the shorter-side direction of the GMR laminated film pattern 301 in the planar view, and arranged sequentially in the longer-side direction of the GMR laminated film pattern in the planar view. The interval between the electrodes 302 and 303 is the same as the one between the electrodes 304 and 305. Such interval is smaller than the one between the electrodes 303 and 304.

The shape of the magneto-resistance effect device can be easily confirmed using the SEM (Scanning Electron Microscope), TEM, or the optical microscope.

In the presence of the substance (detection target) that generates magnetism above the GMR laminated film pattern 301, the signal that reflects the magnitude of the magnetic field can be detected upon change in the electric resistance value in an in-plane direction of the GMR laminated film. In this case, in order to reduce the influence of the contact resistance on the GMR laminated film pattern 301, the electric resistance value of the GMR laminated film is measured by the four-terminal method using the electrodes 302 to 305. When measuring the electric resistance value, the current applied to the entire GMR laminated film pattern 301 is measured in the planar direction of the GMR laminated film pattern 301, that is, the direction along the upper surface of the GMR laminated film pattern 301.

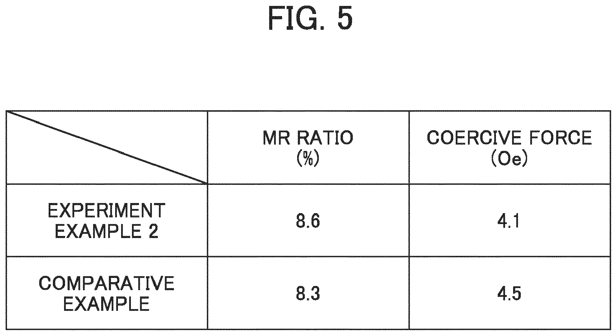

Measurement results of the MR ratio (amount of resistance change) through the DC four-terminal method will be described referring to Fig. 5. Fig. 5 is a table representing values of the MR ratio and the coercive force derived from the experiment example 2 and the comparative example. The coercive force (unit: Oe) is used as the index expressing easiness of change in the magnetizing direction of the ferromagnetic free layer depending on the external magnetic field. Preferably, as the coercive force is lowered, the magnetizing direction of the ferromagnetic free layer becomes more likely to be changed. As the table represents, both sample values of the experiment example 2 and the comparative example indicate high MR ratio in excess of 8%. The coercive force of the sample of either the experiment example 2 or the comparative example is lower than 5 Oe, which exhibits excellent soft magnetic characteristic.

Those results show substantially no change in both the MR characteristic and the magnetic characteristic upon comparison between the cases of using the non-magnetic metal for the protective layer (comparative example), and using the oxide antiferromagnetic substance with thickness of 2.0 nm (experiment example 2). The magnetic susceptibility of the non-magnetic substance is in the range from 1.0 × 10⁻⁴ to 1.0 × 10⁻⁵ approximately. The magnetic susceptibility of the oxide antiferromagnetic substance is in the range from 1.0 × 10⁻⁵ to 1.0 × 10⁻⁶ approximately. The use of the oxide antiferromagnetic substance with magnetic susceptibility lower than that of the non-magnetic substance for the protective layer allows production of the magneto-resistance effect device capable of exhibiting permeability of the magnetic field from above without changing characteristics of the GMR laminated film.

That is, each magnetic field above the magneto-resistance effect element as illustrated in Fig. 2, and above the magneto-resistance effect device as illustrated in Fig. 4 can be efficiently detected. In other words, each detection accuracy, that is, each performance of the magneto-resistance effect element and the magneto-resistance effect device can be improved. This applies to the magneto-resistance effect device provided with the magneto-resistance effect element according to the first embodiment, having no laminated antiferromagnetic structure.

The invention made by the inventors has been described in detail based on the embodiments. The present invention, however, is not limited to those embodiments but may be variously modified without departing from the scope and spirit of the invention.

### Industrial Applicability

The present invention is widely applicable to the magneto-resistance effect element and the magneto-resistance effect device.

### List of Reference Signs

101, 201: substrate,
102, 202: base layer,
103, 203: antiferromagnetic layer,
104: ferromagnetic fixing layer,
105, 207: non-magnetic intermediate layer,
106, 208: ferromagnetic free layer,
107, 209: protective layer,
204: first ferromagnetic fixing layer,
205: non-magnetic coupling layer,
206: second ferromagnetic fixing layer

## Claims

1. A magneto-resistance effect element comprising a magneto-resistance effect laminated film including an antiferromagnetic layer, a first ferromagnetic fixing layer formed on the antiferromagnetic layer, a first non-magnetic layer formed on the first ferromagnetic fixing layer, a ferromagnetic free layer formed on the first non-magnetic layer, and a protective layer formed on the ferromagnetic free layer while being in contact with an upper surface of the ferromagnetic free layer, wherein the protective layer has a film thickness of 10 nm or smaller, and contains an oxide antiferromagnetic substance.

2. The magneto-resistance effect element according to claim 1, wherein:
the protective layer contains an oxide of a first element; and
the first element is one of Ni, Cr, Fe, Co, and Mn.

3. The magneto-resistance effect element according to claim 2, wherein the antiferromagnetic layer contains the oxide of the first element.

4. The magneto-resistance effect element according to claim 1, wherein:
the first non-magnetic layer contains Cu; and
the first ferromagnetic fixing layer or the ferromagnetic free layer contains Fe, Ni, Co, or an alloy thereof.

5. The magneto-resistance effect element according to claim 1, wherein the first ferromagnetic fixing layer includes a second ferromagnetic fixing layer, a second non-magnetic layer formed on the second ferromagnetic fixing layer, and a third ferromagnetic fixing layer formed on the second non-magnetic layer.

6. The magneto-resistance effect element according to claim 5, wherein:
the second ferromagnetic fixing layer or the third ferromagnetic fixing layer contains Co or Co-Fe alloy; and
the second non-magnetic fixing layer contains Ru or Ir.

7. The magneto-resistance effect element according to claim 5, wherein magnetizing directions of the second ferromagnetic fixing layer and the third ferromagnetic fixing layer are antiparallel with each other.

8. The magneto-resistance effect element according to claim 1, wherein the antiferromagnetic layer is made of either an oxide which contains Ni, Cr, Fe, Co or Mn, or a metal which contains Fe, Mn, Pt, or Ir.

9. The magneto-resistance effect element according to claim 1, further comprising:
a base layer formed beneath the antiferromagnetic layer; and
a substrate formed beneath the base layer, wherein the base layer is made of a metal that contains Ta, Ti, Ni, Cr or Fe.

10. A magneto-resistance effect device, comprising:
the magneto-resistance effect element according to claim 1; and
a plurality of electrodes connected to an upper surface of the magneto-resistance effect laminated film.
